# EUROPÄISCHE PATENTSCHRIFT

(11) **EP 2 284 999 B1**
(45) Veröffentlichungstag und Bekanntmachung des Hinweises auf die Patenterteilung: **14.05.2014**
(21) Anmeldenummer: 10167310.1
(22) Anmeldetag: 25.06.2010
(51) Int. Cl.: H03K 17/96, B60R 19/48, H03K 17/955

(54) **Sensormodul**
Sensor module
Module de capteur

(30) Priorität: 20.07.2009 DE 102009027851; 17.12.2009 DE 102009059202
(43) Veröffentlichungstag der Anmeldung: 16.02.2011
(73) Patentinhaber: Huf Hülsbeck & Fürst GmbH & Co. KG, 42551 Velbert (DE)
(72) Erfinder: Van Gastel, Peter, 42699 Solingen (DE); Lindic, Iko, 45149 Essen (DE)
(74) Vertreter: Zenz

(56) Entgegenhaltungen:
- DE-B3-102006 053 572
- US-A- 3 896 425
- US-A- 5 521 515

## Beschreibung

Die Erfindung betrifft ein Sensormodul zum Einsatz in oder an Kraftfahrzeugen.

Insbesondere betrifft die Erfindung ein Sensormodul mit einer Sensorelektrode, mit deren Hilfe das Eindringen eines Objekts in einen Raum vor der Sensorelektrode erfasst werden soll. Wenigstens eine Hilfselektrode erstreckt sich parallel zu der Sensorelektrode.

Derartige Sensoranordnungen kommen an Fahrzeugen in verschiedenen Bereichen zum Einsatz.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass ihr Potential dem Potential der Sensorelektrode nachgeführt wird, ist beispielsweise aus den Veröffentlichungen EP 0 518 836 A1, US 6,825,752 B2, DE 101 31 243 C1 und DE 10 2006 044 778 A1 bekannt. Das aus diesen Druckschriften bekannte Vorsehen einer Schirmelektrode zwischen der Sensorelektrode und der auf Masse-Potential liegenden Hintergrundelektrode hat den Vorteil, dass die Empfindlichkeit des so gebildeten kapazitiven Sensors gegenüber Veränderungen im Raum vor der Sensorelektrode, beispielsweise durch Einbringen von Objekten, erhöht wird. Dies liegt vor allem daran, dass sich das von der Sensorelektrode ausbreitende Feld stärker in den Raum vor der Sensorelektrode (Detektionsbereich) erstreckt, weil nicht mehr - wie bei fehlender Schirmelektrode - ein großer Teil des Feldes zu der auf Masse-Potential liegenden Hintergrundelektrode kurzgeschlossen wird. Aufgrund des Umstands, dass die Schirmelektrode derart mit der Sensorelektrode gekoppelt ist, dass sie deren Potential nachgeführt wird, entsteht das starke elektrische Feld zwischen der Schirmelektrode und der Hintergrundelektrode; vor allem aber bildet sich praktisch kein Feld aus zwischen der Sensorelektrode und der potentialmäßig nachgeführten Schirmelektrode.

Die bekannte Anordnung von Sensorelektrode, Schirmelektrode und Hintergrundelektrode ist üblicherweise von einem elektrischen Isolator, beispielsweise einem Kunststoff, umhüllt, so dass sich eine Isolatorschicht, beispielsweise Kunststoffschicht, auf der Sensorelektrode und somit zwischen der Sensorelektrode und dem zu überwachenden Raum vor der Sensorelektrode, das heißt dem Detektionsbereich, befindet.

Die US 3,896,425 offenbart eine kapazitive Sensoranordnung, bei welcher eine Sensorelektrode aus einem Abschnitt eines Kabels gebildet ist, welcher in Trägern gehalten ist.

Ein weiterer, sogenannter Capaciflector ist in der US 5,521,515 offenbart, wobei eine Verstimmung eines elektrischen Schwingkreises zur Detektion verwendet wird. Die Fertigung und die Wartung derartiger Sensoranordnung ist aufwändig und kostspielig. Insbesondere die Ausrichtung der Elektroden zueinander und die dauerhafte Fixierung der Ausrichtung über die gesamte Länge auch während des Betriebes sind kritische Faktoren.

Der Erfindung liegt daher die Aufgabe zugrunde, bei einer Sensoranordnung der eingangs genannten Art eine preisgünstigere und robuste Fertigung zu ermöglichen.

Erfindungsgemäß wird diese Aufgabe durch eine Sensoranordnung mit den Merkmalen des Anspruchs 1 gelöst.

Das erfindungsgemäße kapazitive Sensormodul weist eine Sensorelektrode auf, mit deren Hilfe das Eindringen eines Objekts in einen Raum vor der Sensorelektrode erfasst werden kann. Die Sensorelektrode ist aus einem Abschnitt eines ersten Kabels oder Drahts gebildet. Wenigstens eine erste Hilfselektrode erstreckt sich parallel zu der Sensorelektrode, wobei die erste Hilfselektrode aus einem Abschnitt eines zweiten Kabels oder Drahtes gebildet ist.

Ein Kunststoffträger weist Ausnehmungen zur Aufnehmung und Führung der Sensorelektrode auf, wobei jeweils wenigstens eine Ausnehmung in länglicher Form zur Aufnahme einer Sensorelektrode ausgebildet ist. In den Ausnehmungen werden die Sensorelektroden entlang ihres Umfangs wenigstens teilweise durch den Kunststoffträger umgriffen und so in der Ausnehmung gehalten. Der Kunststoffträger und die Begrenzungen der Ausnehmungen sind so gebildet, und in ihrer Formgebung und Materialwahl auf die Sensorelektroden abgestimmt, dass die Sensorelektroden in die Ausnehmungen durch Aufbringung einer elastischen oder plastischen Verformungskraft eindrückbar sind und durch die elastische Rückformungen in ihren Ausnehmungen gehalten werden.

Je nachdem, ob es sich bei den Sensorelektroden um ummantelte Kabel oder Drähte handelt, kann ein Teil oder die gesamte Verformung in den Kabeln stattfinden oder sowohl die Kunststoffträgeraufnahme als auch das Kabel oder nur die Kunststoffträgeraufnahme verformt werden.

Erfindungsgemäß wird demnach ein Sensormodul zur Verfügung gestellt, welches in einfacher Weise und aus separaten Komponenten die Ausbildung eines sensiblen kapazitiven Annäherungssensors ermöglicht. Die Sensorelektroden werden als Kabel oder Drähte in den Träger eingedrückt und in diesem in definiertem Abstand zueinander gehalten. Über die gesamte Halterungsstrecke ist mit dem erfindungsgemäßen Träger eine stabile Beabstandung und Ausrichtung sichergestellt. Durch die Trägerformung ist es möglich, die Sensorelektroden reproduzierbar und präzise in einer gewünschten Anordnung und Ausrichtung zueinander zu führen.

Die Ausbildung mit getrennten Komponenten für die Sensorelektroden einerseits und den Träger andererseits ermöglicht eine äußerst günstige Herstellung. Der Träger kann üblicherweise durch Extrusion aus einem geeigneten Kunststoffmaterial hergestellt werden, während es sich bei den Kabeln oder Drähten um verfügbare Massenware handeln kann. Die einzelnen Komponenten sind sowohl einfach miteinander zu verbinden als auch wieder von einander trennbar, was eine Instandsetzung im Falle eines Defektes erleichtert.

Die Ausnehmungen können, je nach Anforderung, so ausgebildet sein, dass sie vertauschungssicher vorliegen, also zum Beispiel mit unterschiedlichen Größen für unterschiedliche Draht- oder Kabeldurchmesser. Auf diese Weise können Sensorelektrode und Hilfselektroden aus verschiedenen Kabelarten gebildet sein. Bei der Montage ist eine Verwechselung der jeweiligen Kabel aufgrund der vorgegebenen Halterungsausnehmung weitgehend ausgeschlossen.

Gemäß der Erfindung kann der Träger als gradliniger Körper mit parallelen gradlinigen Leitungsabschnitten gebildet sein. Es ist jedoch auch möglich, den Träger mit einer Wölbung oder Biegung auszubilden, zum Beispiel wenn das Sensormodul in entsprechend geformte Teile eines Kraftfahrzeugs eingesetzt werden soll.

Gemäß der Erfindung sind nicht nur eine Sensorelektrode und eine erste Hilfselektrode in dem Träger aufgenommen, sondern eine weitere Hilfselektrode ist zur Aufnahme vorgesehen. Auf diese Weise eine Eingangs erläuterte Anordnung mit Sensorelektrode, Schirmelektrode (erster Hilfselektrode) und Hintergrundelektrode (zweiter Hilfselektrode) realisiert werden. Die Elektroden sind dabei üblicherweise in gradliniger Anordnung in entsprechenden Aufnahmen gehalten.

Außerdem weisen die drei nebeneinander bzw. hintereinander liegenden Elektroden variierende Abstände auf, wobei die Sensorelektrode von den übrigen beiden Hilfselektroden weiter beabstandet ist als die Hilfselektroden untereinander beabstandet sind. Mit anderen Worten, zwischen Sensorelektrode und Schirmelektrode ist ein größerer Abstand ausgebildet als zwischen Schirmelektrode und Hintergrundelektrode.

In einer weiteren Ausführungsform ist wenigstens eine der Elektroden aus einem ummantelten Kabel gebildet. Es ist grundsätzlich möglich, eine oder mehrere der Elektroden aus Drähten zu bilden, um die Ausbreitung und Detektion von elektrischen Feldern in geringst möglichem Umfang zu beeinflussen. Vorzugsweise werden jedoch ummantelte Kabel aufgrund der Einfachheit der Handhabung, der Robustheit und ihrer Unempfindlichkeit gegenüber Umwelteinflüssen verwendet.

In einer bevorzugten Ausführungsform weist der Träger einen Halteabschnitt und einen Befestigungsabschnitt auf, wobei der Halteabschnitt zum Halten der verschiedenen Elektroden vorgesehen ist und die entsprechenden Ausnehmungen aufweist. Der Befestigungsabschnitt dient der Platzierung und Befestigung des Sensormoduls am Bestimmungsort, zum Beispiel an der Innenseite eines Stoßfängers in einem Kraftfahrzeug. Der Befestigungsabschnitt kann dazu Befestigungsmittel aufweisen. Alternativ kann der Befestigungsabschnitt an seinem Bestimmungsort verklebt werden.

Eine bevorzugte Art der Befestigung des Sensormoduls ist die Verwendung eines am Bestimmungsort vorgesehenen Clips, der den Befestigungsabschnitt am Sensormodul umgreifen kann, so dass das Sensormodul stabil aber lösbar in dem Clip aufgenommen ist. Der Clip kann dazu beispielsweise aus Federstahl oder aus einem elastischen Kunststoff gebildet sein.

In einer weiteren Ausführungsform ist der Träger integral mit einem entsprechenden Bauteil eines Kraftfahrzeuges ausgebildet, zum Beispiel einem Stoßfänger. Ein Abschnitt des entsprechenden Kraftfahrzeugbauteils weist dann die Ausnehmungen auf, in welche die Sensorelektroden eingelegt werden. Auf diese Weise ist es möglich, entsprechende Ausnehmungen in sämtlichen Bauteilen einer Baureihe vorzusehen, jedoch eine Ausstattung mit den entsprechenden Elektroden und Schaltungen nur dort vorzusehen, wo diese Funktion beim entsprechenden Fahrzeug auch tatsächlich gewünscht ist.

Vorteilhafte und/oder bevorzugte Ausführungsformen sind in den Unteransprüchen gekennzeichnet.

Die Erfindung wird nun anhand der beiliegenden Figuren näher erläutert.
Figur 1 zeigt den Träger eines erfindungsgemäßen Sensormoduls gemäß einer ersten Ausführungsform;
Figur 2 zeigt eine Stirnansicht eines erfindungsgemäßen Sensormoduls;
Figur 3 zeigt das Sensormodul aus Figur 2 in einer perspektivischen Ansicht;
Figur 4 zeigt in schematische Ansicht die Kopplung des Sensormoduls mit einer Steuer- und Auswerteschaltung.

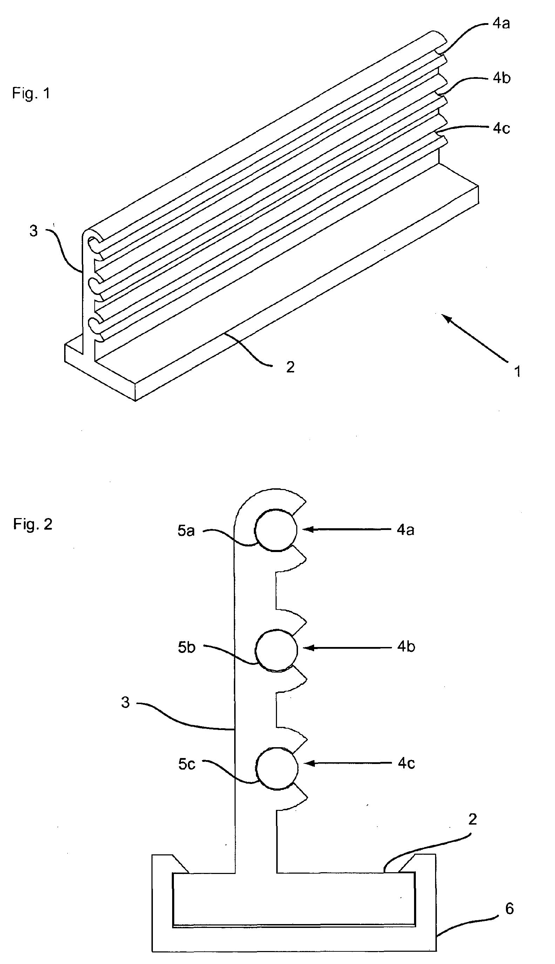

In Figur 1 ist ein Träger 1 dargestellt, welcher über einen Befestigungsabschnitt 2 sowie einen Halterabschnitt 3 verfügt. In dem Halterabschnitt 3 sind Ausnehmungen 4A, 4B, 4C gebildet, welche zur Aufnahme der Elektroden dienen. Der Träger 1 ist aus einem Kunststoff als Extrusionskörper gebildet. Die Ausnehmungen 4A, 4B, 4C weisen jeweils in ihren Querschnitt kreisförmige Freiräume auf, die entlang eines Kreisabschnittes geöffnet sind. Durch diese Öffnungen können Kabel oder Drähte eingedrückt werden, um in den Ausnehmungen gehalten zu sein.

Figur 2 zeigt den Träger mit eingelegten Elektroden 5A, 5B und 5C sowie einen Befestigungsclip 6.

Die Elektrode 5A ist in die Ausnehmung 4A eingelegt, die Elektrode 5B in die Ausnehmung 4B, die Elektrode 5C in die Ausnehmung 4C.

Der Befestigungsabschnitt 2 ist von dem Clip umgriffen und ortsfest fixiert. Der Clip 6 weist eine entsprechende Elastizität und Abschrägung der Aufnahmekanten auf, um den Befestigungsabschnitt 2 einfach in den Clip 6 einschieben zu können.

In dieser Ansicht ist erkennbar, dass die Drähte bzw. Kabel 5A, 5B, 5C in ihren jeweiligen eingelegten Stellungen gehalten werden, da sie entlang ihres Umfanges zu mehr als der Hälfte der Umfangslinie umgriffen sind. Obwohl in diesem Beispiel die Kabel äquidistant verteilt angeordnet sind, ist eine Verteilung mit unterschiedlichen Abständen problemlos realisierbar. Auch unterschiedliche Drahtstärken können problemlos verwendet werden.

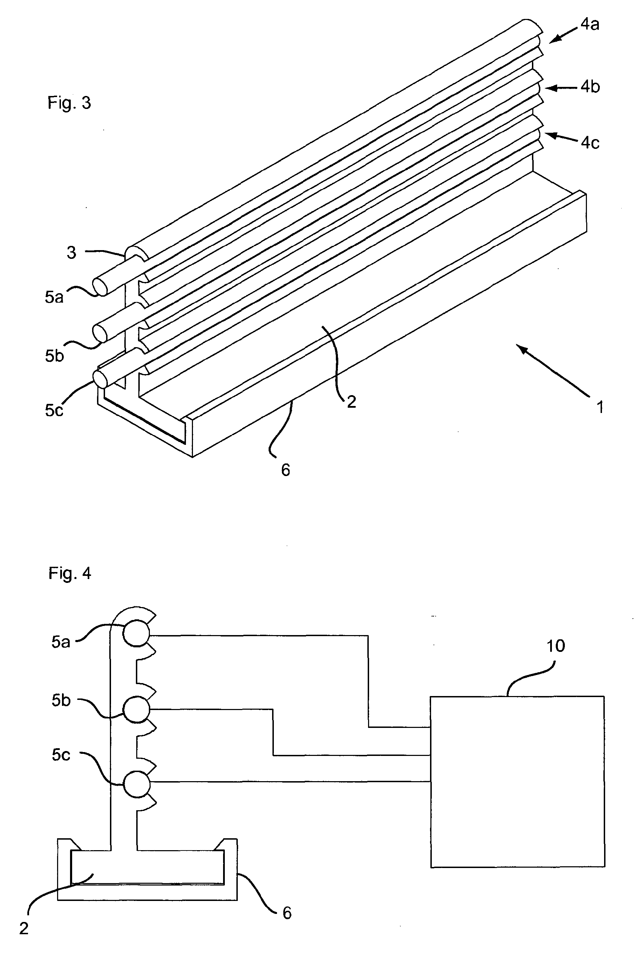

Figur 3 zeigt die Einrichtung aus Figur 2 in einer perspektivischen Ansicht, wobei die Kabel bzw. Drähte 5A, 5B, 5C teilweise aus dem Träger herausgeführt sind. In diesem Abschnitt wird die Steuer- und Auswerteelektronik angekoppelt.

Figur 4 zeigt eine Prinzipdarstellung der entsprechenden Verschaltung des erfindungsgemäßen Sensormoduls. Die Elektrode 5A ist als zweite Hilfselektrode bzw. Hintergrundelektrode mit der Steuerschaltung 10 verbunden und liegt auf dem Massepotential. Die Elektrode 5B dient als aktive Schirmelektrode bzw. erste Hilfselektrode und ist ebenfalls mit der Steuerschaltung 10 verbunden. Die Sensorelektrode 5C ist benachbart zu dem Befestigungsabschnitt 2 angeordnet und ebenfalls mit der Steuerschaltung 10 verbunden.

In einem derartigen Aufbau würde die Elektrode beim Einbau am Fahrzeug beispielsweise so ausgerichtet werden, dass der Clip 6 an der Innenseite eines Stoßfängers angeordnet ist, so dass die Elektrode 5A dem Fahrzeug zugewandt ist. Die Sensorelektrode 5C ist dann der Stoßfängerseite zugewandt und kann beispielsweise die Annäherung von Beinen oder Füßen von einem Benutzer erfassen. Auf diese Weise kann beispielsweise eine Fußannäherung im Bereich unterhalb eines Stoßfängers detektiert werden, um eine automatische Öffnung einer Heckklappe des zugehörigen Fahrzeuges auszulösen.

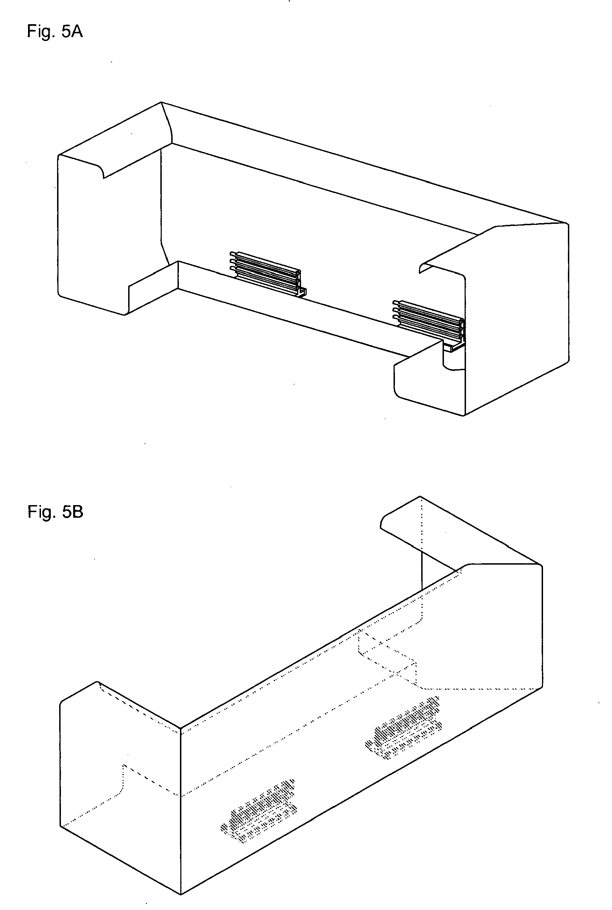

Eine entsprechende Anordnung des Ausführungsbeispiels in einem Stoßfänger ist in den Abbildungen 5A und 5B gezeigt. Zwei Sensormodule sind auf der dem Straßenbelag zugewandten Innenseite eines Stoßfängers angeordnet.

Die Steuer- und Auswerteschaltung 10 erfasst eine Änderung der Kapazität der Sensorelektrode 5C gegenüber einem Referenzpotential, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode 5C mit der vorgegebenen Frequenz periodisch wiederholt mit einem vorgegebenen Potential, beispielsweise dem Betriebsspannungspotential, koppelt. Der Spannungsverlauf kann beispielsweise der Spannungsverlauf am Anschluss der Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der Sensorelektrode gemessene Spannung sein. Die Schirmelektrode 5B ist über die Steuer- und Auswerteschaltung derart mit der Sensorelektrode gekoppelt, dass ihr Potential dem Potential der Sensorelektrode im wesentlichen nachgeführt wird. Die Kopplung erfolgt derart, dass die Schirmelektrode 5B keinen Einfluss auf die gegenüber dem Referenzpotential gemessene Kapazitätsänderung der Sensorelektrode hat. Mit dem Begriff des "Nachführens" soll hier zum Ausdruck gebracht werden, dass das Potential der Schirmelektrode 5B nicht gleich dem Potential der Sensorelektrode 5C zu sein braucht und dass es einen zeitlichen Versatz zwischen dem Verlauf des Potentials der Sensorelektrode und dem Potential der Schirmelektrode geben kann. Mit den Worten "im Wesentlichen" soll darüber hinaus zum Ausdruck gebracht werden, dass die Schirmelektrode nicht über die vollen Perioden des Ladens und Entladens der Sensorelektrode dem Potential der Sensorelektrode folgen muss; es genügt, wenn sie diesem Potential zumindest in Teilabschnitten der Perioden folgt, beispielsweise während des Aufladens der Sensorelektrode deren Potential folgt und während des Entladens der Sensorelektrode auf das Masse-Referenzpotential abfällt, während das Potential der Sensorelektrode noch auf einem von Masse verschiedenen Potential verbleibt.

Die Hintergrundelektrode wird beispielsweise auf ein konstantes Potential, wie Masse oder Betriebsspannung, gelegt. Alternativ kann die Hintergrundelektrode periodisch mit der vorgegebenen Frequenz abwechselnd auf Masse und ein weiteres Potential, beispielsweise die Betriebsspannung gelegt werden, wobei dies vorzugsweise komplementär zur Sensorelektrode erfolgt, wie dies beispielsweise in der parallel anhängigen Patentanmeldung der Anmelderin mit dem Titel "Kapazitive Sensoranordnung mit einer Sensorelektrode, einer Schirmelektrode und einer Hintergrundelektrode" beschrieben ist. Der Detektionsbereich der Sensoranordnung erstreckt sich, ausgehend von der Sensorelektrode 4C in einen Winkelbereich, welcher von der Schirmelektrode 5B abgewandt ist.

Die gesamte Anordnung oder einzelne Elektroden können von Isolatormaterialien umgeben sein. So kann insbesondere zwischen der Sensorelektrode und dem Detektionsbereich eine die Sensorelektrode umgebende Kunststoffschicht vorgesehen sein. Insbesondere ist es vorteilhaft, wenn diese Schicht einer ersten Dicke und eine in einem vorgegebenen Abstand angeordnete äußere Kunststoffschicht einer zweiten Dicke umfasst ist, wobei die Isolatormaterialschichten so angeordnet sind, dass die relative Dielektrizitätskonstante mit zunehmender Entfernung von der Sensorelektrode zunächst einen relativ hohen Wert der umgebenden Kunststoffschicht annimmt, dann auf einen sich dem Wert 1 annähernden Wert (beispielsweise den von Luft) abfällt und dann wieder auf einen relativ hohen Wert der äußeren Kunststoffschicht ansteigt.

Es zeigte sich, dass bei einer gezielten Schaffung eines Zwischenraums zwischen der eine ggf. durch Umwelteinflüsse kontaminierte Außenfläche bildenden Kunststoffschicht und der die Sensorelektrode umhüllenden Kunststoffschicht mit einer dem Wert 1 angenäherten Dielektrizitätskonstante die störenden Einflüsse der Feuchtekontamination verringert oder vermieden werden konnten. Entsprechende zusätzliche Schichten können z.B. durch gängige Beschichtungsverfahren im Abschluss der Montage aufgebracht werden.

Im Rahmen der Erfindung sind zahlreiche Abwandlungen möglich. Insbesondere ist der Kunststoffträger in beliebiger Weise zu gestalten, zum Beispiel mit weiteren Befestigungsabschnitten, mit mechanischen Stabilisierungsverstrebungen oder -verdickungen oder aus verschiedensten Materialien. Wesentlich ist, dass der Träger Ausnehmungen aufweist, in welche die Drähte oder Kabel zur Bildung von Sensor- oder Hilfselektroden einlegbar sind und dort gehalten werden.

Es ist grundsätzlich auch möglich Träger auszubilden, deren Anzahl von Ausnehmungen die Anzahl der im Anwendungsfall zu verwendenden Elektroden übersteigt. Beispielsweise können dann universelle Träger gebildet werden, bei denen je nach Bedarf in unterschiedlichem Abstand Sensorkabel eingelegt werden oder Sensorkabel mit unterschiedlichem Querschnitt eingelegt werden. Ein und derselbe Träger kann daher zur Bildung verschiedener Sensoranordnungen verwendet werden.

## Patentansprüche

1. Kapazitives Sensormodul mit
einer Sensorelektrode (4c), wobei die Sensorelektrode aus einem Abschnitt eines ersten Kabels oder Drahts gebildet ist,
wenigstens einer sich parallel zu der Sensorelektrode (5c) erstreckenden ersten Hilfselektrode (5b), wobei die Hilfselektrode aus einem Abschnitt eines zweiten Kabels oder Drahtes gebildet ist,
einem Kunststoffträger (3), welcher Ausnehmungen (4a, 4b, 4c) zur Aufnahme und Führung der Sensorelektrode und den Hilfselektroden aufweist, wobei die Ausnehmungen derart ausgebildet sind, dass sie die Elektroden entlang deren Umfang wenigstens teilweise umgreifen und in der Ausnehmung halten, wobei sie entlang ihres Umfanges zu mehr als der Hälfte der Umfangslinie umgriffen sind,
wobei die Elektroden in die jeweiligen Ausnehmungen durch Überwindung einer elastischen Verformungskraft eindrückbar sind und durch die elastische Rückformung des Trägers und/oder der Elektrode in ihren jeweiligen Ausnehmungen gehalten werden,
**gekennzeichnet durch**
eine sich parallel zu erster Hilfselektrode (5b) und Sensorelektrode (5c) erstreckenden zweiten Hilfselektrode (5a), wobei Sensorelektrode, erste Hilfselektrode und zweite Hilfselektrode in dieser Reihenfolge und in gerader Linie angeordnet sind,
wobei die erste, äußere Ausnehmung (4c) zur Aufnahme der Sensorelektrode (5c) vorgehen ist und diese zu der benachbarten Ausnehmung (4b) für die erste Hilfselektrode (5b) einen Abstand aufweist, welcher größer ist als der Abstand zwischen der Ausnehmung (4b) für die erste Hilfselektrode (5b) und der Ausnehmung (4a) für die zweite Hilfselektrode (5a).

2. Kapazitives Sensormodul nach Anspruch 1, wobei wenigstens eine der Elektroden aus einem ummantelten Kabel gebildet ist, wobei die Ummantelung aus einem elastischen Weichkunststoff gebildet ist.

3. Kapazitives Sensormodul nach einem der vorangehenden Ansprüche, wobei der Träger einen Halteabschnitt und einen integral verbundenen Befestigungsabschnitt aufweist, wobei in dem Halteabschnitt die Aufnahmen für die Elektroden angeordnet sind.

4. Kapazitives Sensormodul nach Anspruch 3, wobei eine zur Befestigung vorgesehene Klammer den Befestigungsabschnitt umgreift, wobei der Befestigungsabschnitt in die Klammer lösbar einklippbar ist.

5. Kapazitives Sensormodul nach einem der vorangehenden Ansprüche, wobei der Träger integral mit einem Bauteil eines Stoßfängers für ein Kraftfahrzeug ausgebildet ist.

6. Kapazitives Sensormodul nach einem der vorangehenden Ansprüche, wobei
mit der Sensorelektrode eine Steuer- und Auswerteschaltung gekoppelt ist, welche eine Änderung der Kapazität der Sensorelektrode gegenüber einem Referenzpotential erfasst, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet.

7. Kapazitives Sensormodul nach Anspruch 6, wobei die erste Hilfselektrode über die Steuer- und Auswerteschaltung derart mit der Sensorelektrode gekoppelt ist, dass ihr Potential dem Potential der Sensorelektrode im Wesentlichen nachgeführt wird.

## Claims

1. A capacitive sensor module with
a sensor electrode (4c), wherein
the sensor electrode is formed from a section of a first cable or wire,
at least one ancillary electrode (5b) extending parallel to the sensor electrode (5c), wherein
the ancillary electrode is formed from a section of a second cable or wire,
a plastic carrier (3), which has recesses (4a, 4b, 4c) for the accommodation and guidance of the sensor electrodes and the ancillary electrode, wherein the recesses are designed such that they at least partially encompass the electrodes along their periphery and retain them in the recess, wherein the electrodes are encompassed along their periphery by more than half the perimeter,
wherein the electrodes can be pressed into the respective recesses by overcoming an elastic deformation force, and are retained in their respective recesses by the elastic restoration of the shape of the carrier and/or the electrode,
**characterised by**
a second ancillary electrode (5a) extending parallel to the first ancillary electrode (5b) and the sensor electrode (5c), wherein the sensor electrode, first ancillary electrode and second ancillary electrode are arranged in this order and in a straight line, wherein the first, outer recess (4c) is provided for the accommodation of the sensor electrode (5c), and this has a separation distance from the adjacent recess (4b) for the first ancillary electrode (5b) that is greater than the separation distance between the recess (4b) for the first ancillary electrode (5b) and the recess (4a) for the second ancillary electrode (5a).

2. The capacitive sensor module in accordance with claim 1, wherein at least one of the electrodes is formed from a sheathed cable, wherein the sheathing is formed from an elastic soft plastic.

3. The capacitive sensor module in accordance with one of the preceding claims, wherein the carrier has a retaining section and an integrally connected attachment section, wherein the recesses for the electrodes are arranged in the retaining section.

4. The capacitive sensor module in accordance with claim 3, wherein a clip provided for purposes of attachment encompasses the attachment section, wherein the attachment section can be clipped into the clip such that it can be released.

5. The capacitive sensor module in accordance with one of the preceding claims, wherein the carrier is designed integrally with a component of a bumper for a motor vehicle.

6. The capacitive sensor module in accordance with one of the preceding claims, wherein
a control and evaluation circuit is coupled with the sensor electrode, which circuit registers an alteration of the capacity of the sensor electrode with respect to a reference potential, in that it periodically charges and discharges the sensor electrode with a prescribed frequency, and evaluates at least one parameter of a current or voltage characteristic dependent on the periodic charging and discharging of the sensor electrode, for purposes of registering the alteration of capacity.

7. The capacitive sensor module in accordance with claim 6, wherein the first ancillary electrode is coupled with the control and evaluation circuit such that its potential is essentially tracked to the potential of the sensor electrode.

## Revendications

1. Module de capteur capacitif avec
une électrode de capteur (4c), l'électrode de capteur étant formée par un segment d'un premier câble ou fil,
au moins une première électrode auxiliaire (5b) s'étendant parallèlement à l'électrode de capteur (5c), moyennant quoi
l'électrode auxiliaire est formée par un segment d'un deuxième câble ou fil,
un support plastique (3), lequel présente des logements (4a, 4b, 4c) pour la réception et le guidage de l'électrode de capteur et des électrodes auxiliaires, moyennant quoi les logements sont réalisés de manière à entourer au moins partiellement les électrodes le long de leur périphérie et à les maintenir dans le logement, moyennant quoi elles sont entourées le long de leur périphérie de l'ordre de plus de la moitié de la ligne périphérique,
les électrodes pouvant être pressées dans les logements respectifs en surmontant une force de déformation élastique et pouvant être maintenues dans leurs logements respectifs grâce au redressage élastique du support et/ou de l'électrode,
**caractérisé par**
une deuxième électrode auxiliaire (5a) s'étendant parallèlement à la première électrode auxiliaire (5b) et à l'électrode de capteur (5c), moyennant quoi l'électrode de capteur, la première électrode auxiliaire et la deuxième électrode auxiliaire sont disposées dans cet ordre et en ligne droite,
le premier logement (4c) extérieur étant prévu pour la réception de l'électrode de capteur (5c) et celui-ci présentant un espacement par rapport au logement (4b) voisin pour la première électrode auxiliaire (5b), lequel est supérieur à l'espacement entre le logement (4b) pour la première électrode auxiliaire (5b) et le logement (4a) pour la deuxième électrode auxiliaire (5a).

2. Module de capteur capacitif selon la revendication 1, dans lequel au moins l'une des électrodes est formée par un câble gainé, la gaine étant formée par un plastique mou élastique.

3. Module de capteur capacitif selon l'une des revendications précédentes, dans lequel le support présente un segment de maintien et un segment de fixation intégralement relié, les logements pour les électrodes étant disposés dans le segment de maintien.

4. Module de capteur capacitif selon la revendication 3, dans lequel une bride de fixation prévue pour la fixation entoure le segment de fixation, le segment de fixation pouvant être encliqueté de manière détachable dans la bride de fixation.

5. Module de capteur capacitif selon l'une des revendications précédentes, dans lequel le support est réalisé intégralement avec un composant d'un parechocs pour un véhicule automobile.

6. Module de capteur capacitif selon l'une des revendications précédentes, dans lequel un circuit de commande et d'analyse est couplé à l'électrode de capteur, lequel détecte une modification de la capacité de l'électrode de capteur par rapport à un potentiel de référence en ce qu'il charge et décharge périodiquement l'électrode de capteur concernant une fréquence prescrite, et analyse au moins un paramètre d'une variation de courant ou de tension dépendant de la charge et décharge périodique du capteur d'électrode pour la détection de la modification de la capacité.

7. Module de capteur capacitif selon la revendication 6, dans lequel la première électrode auxiliaire est couplée par l'intermédiaire du circuit de commande et d'analyse à l'électrode de capteur de manière à ce que son potentiel soit sensiblement asservi au potentiel de l'électrode de capteur.
